# EUROPÄISCHE PATENTSCHRIFT

(11) **EP 1 218 950 B1**
(45) Veröffentlichungstag und Bekanntmachung des Hinweises auf die Patenterteilung: **01.06.2005**
(21) Anmeldenummer: 00963970.9
(22) Anmeldetag: 06.09.2000
(51) Int. Cl.: H01L 51/20

(54) **VERFAHREN ZUR VERKAPSELUNG VON BAUELEMENTEN**
METHOD FOR ENCAPSULATING COMPONENTS
PROCEDE D'ENCAPSULAGE DE COMPOSANTS

(30) Priorität: 09.09.1999 DE 19943149
(43) Veröffentlichungstag der Anmeldung: 03.07.2002
(73) Patentinhaber: Osram Opto Semiconductors GmbH, 93049 Regensburg (DE)
(72) Erfinder: BAYER, Heiner, D-82140 Olching (DE); ROTH, Wolfgang, 91080 Uttenreuth (DE); ROGLER, Wolfgang, 91096 Möhrendorf (DE)
(74) Vertreter: Epping Hermann & Fischer
(86) Internationale Anmeldenummer: PCT/DE2000/003084
(87) Internationale Veröffentlichungsnummer: WO 2001/018887

(56) Entgegenhaltungen:
- EP-A- 0 430 273
- EP-A- 0 781 075
- US-A- 5 895 228

## Beschreibung

Die Erfindung betrifft ein Verfahren zur Verkapselung von Bauelementen auf Basis organischer Halbleiter, insbesondere von organischen lichtemittierenden Dioden, wobei ein Gehäuse mit einem Substrat verklebt wird.

Bauelemente, deren Funktion auf der Verwendung organischer Halbleiter beruht, müssen wirksam vor Umgebungseinflüssen geschützt werden, insbesondere vor einer Degradation durch Luft oder Feuchte. Dazu dient im allgemeinen ein Gehäuse, das beispielsweise auch eine flächige Abdeckung sein kann.

Bauelemente auf der Basis von organischen Halbleitern sind insbesondere organische lichtemittierende Dioden (OLEDs). Derartige lichtemittierende Dioden weisen organische Monomere oder Polymere auf, die zwischen Elektroden angeordnet sind, wobei eine Elektrode transparent ist. Beim Anlegen einer Spannung an die Elektroden erfolgt die Emission von Licht. OLEDs weisen dazu typischerweise ein organisches elektrolumineszierendes Material (Emitter), ein organisches Lochtransportmaterial und ein organisches Elektronentransportmaterial auf. Diese Materialien sowie das Kathodenmaterial müssen vor einer Degradation durch Luft (Sauerstoff) und Wasser geschützt werden, wozu eine effiziente Kapselung erforderlich ist.

Die Kapselung von OLEDs kann in unterschiedlicher Weise erfolgen, beispielsweise durch Glaslöten, d.h. durch Verbinden von (Glas-)Teilen mittels eines Glaslots (deutsche Patentanmeldung Akt.Z. 198 45 075.3). Es ist auch bereits eine elektrolumineszierende Anordnung bekannt, bei der das elektrolumineszierende Element in ein Gehäuse eingeschlossen ist, das aus einem das elektrolumineszierende Element tragenden Substrat und einer Deckschicht aus einem niedrigschmelzenden Metall oder einer entsprechenden Legierung besteht, die mit einer elektrisch leitenden Klebeschicht versehen ist (WO 97/46052). Nachteilig ist hierbei, daß durch die relativ hohen Temperaturen, die zur Verarbeitung des Glaslots bzw. des Metalls oder der Legierung aus der Schmelze erforderlich sind, das elektrolumineszierende Element geschädigt werden kann.

Eine organische elektrolumineszierende Vorrichtung mit einer flächigen Abdeckung ist aus der EP 0 468 440 Bl bekannt. Hierbei liegt auf der Kathode eine Schutzschicht auf, die aus einer Mischung aus wenigstens einer Komponente des organischen elektrolumineszierenden Mediums und mindestens einem Metall mit einer Austrittsarbeit im Bereich von 4 bis 4,5 eV besteht. Die Schutzschicht wird durch Coverdampfen der genannten Materialien hergestellt, was aber einen großen Aufwand bedeutet.

Aus "Applied Physics Letters", Vol. 65 (1994), Seiten 2922 bis 2924 ist es bekannt, die auf einem Glassubstrat angeordnete OLED mit einer Glasplatte abzudecken und diese mit dem Glassubstrat zu verkleben; die Verklebung kann mit einem kommerziellen Epoxid-Klebstoff erfolgen. Die Verwendung eines Epoxids zur Abdichtung von organischen lichtemittierenden Vorrichtungen ist auch aus den US-Patentschriften 5 703 394 und 5 747 363 bekannt.

Aus der DE 196 03 746 A1 ist eine elektrolumineszierende Vorrichtung (mit lichtemittierendem organischen Material) mit einer Kapselung bekannt, die ein Mehrschichtsystem ist. Dieses Mehrschichtsystem besteht aus wenigstens einer Schicht aus Kunststoff und einer metallhaltigen Schicht. Zusätzlich kann eine sogenannte Getterschicht vorhanden sein, die zwischen zwei Kunststoffschichten eingebettet ist. Die Kunststoffschichten können unter anderem aus einem Epoxidharz bestehen.

Bei Untersuchungen an organischen lichtemittierenden Dioden, beispielsweise bei Lagertests bei einer Temperatur von 85°C und einer relativen Feuchte von 85 %, konnte aber kein kommerziell erhältlicher Klebstoff ermittelt werden, der weder die als Kathodenmaterial eingesetzten unedlen Metalle korrodiert noch die lichtemittierenden Materialien beeinträchtigt.

Aufgabe der Erfindung ist es deshalb, ein Verfahren zur Verkapselung von Bauelementen auf der Basis von organischen Halbleitern anzugeben, das einerseits eine hermetische Kapselung erlaubt, so daß schädliche Umwelteinflüsse ausgeschlossen sind, und andererseits nicht zu einer Schädigung der in den Bauelementen verwendeten Materialien führt.

Dies wird erfindungsgemäß dadurch erreicht, daß zur Verklebung ein UV-härtbarer Reaktionsklebstoff eingesetzt wird, der folgende Komponenten enthält:
- ein Epoxidharz,
- ein hydroxyfunktionelles Umsetzungsprodukt einer Epoxidverbindung mit einer phenolischen Verbindung,
- einen Haftvermittler vom Silantyp und
- einen Photoinitiator sowie
- gegebenenfalls Füllstoff.

Das angegebene technische Problem wird gemäß der Erfindung durch Fügen vorgegebener Teile mittels eines eigens formulierten Klebstoffes auf Epoxidharzbasis gelöst. Die vorgegebenen Teile umfassen dabei ein Gehäuse und ein Substrat, auf dem sich der organische Halbleiter sowie die anderen zur Funktion des Bauelementes notwendigen Materialien befinden, beispielsweise Metalle als Leiterbahnen. Als Substrat dienen insbesondere Glassubstrate, es können aber auch Kunststoff-Folien oder Kunststoff/Glas-Verbünde eingesetzt werden. Das Gehäuse kann eine Platte sein, insbesondere eine Glasplatte, vorzugsweise ist es eine Kappe, die insbesondere aus Glas besteht, aber auch aus Keramik oder Metall sein kann.

Der erfindungsgemäß zum konstruktiven Dichtkleben verwendete Klebstoff, der ohne großen Aufwand appliziert werden kann, ist vorteilhafterweise flüssig oder niedrigschmelzend und damit benetzend. Er eignet sich deshalb insbesondere für einen Kapillarverguß, d.h. zur Füllung dünner Fugen, kann zusätzlich aber auch als Gießharz oder Lack verwendet werden.

Durch die Verwendung des Klebstoffes nach der Erfindung ergeben sich folgende Vorteile:
- kostengünstiges und automatisierbares Verfahren;
- schneller Prozeß;
- Niedrigtemperaturprozeß, deshalb keine Schädigung des organischen Halbleiters;
- keine aufwendige Isolierung benachbarter Leiterbahnen, welche die Klebezone passieren, aufgrund der elektrisch isolierenden Eigenschaft des Klebstoffes.

Spezielle Vorteile des Klebstoffes sind:
- Einkomponentensystem, bei Raumtemperatur mindestens 1 Jahr lagerfähig;
- kein Ausdampfen flüchtiger, die Funktion des Bauelementes schädigender Bestandteile;
- hohe Haftung zu Glas über einen weiten Temperaturbereich;
- über einen weiten Temperaturbereich ausreichende Flexibilität, dadurch Minimierung von mechanischem Streß infolge thermischer Belastung;
- optische Transparenz;
- hohe O₂- und H₂O-Diffusionssperre;
- elektrisch isolierende Wirksamkeit;
- Verarbeitbarkeit unter inerten Bedingungen;
- rasche Härtung durch UV-Bestrahlung.

Durch die spezielle Formulierung des Klebstoffes werden insbesondere eine hohe Kompatibilität mit Bauelementen sowie eine wirksame Luft- und Feuchtesperrwirkung erreicht. Deshalb ist dieser Klebstoff zur Kapselung von Bauelementen auf Basis organischer Halbleiter, insbesondere von lichtemittierenden Dioden, hervorragend geeignet.

Bei der Verwendung von Kappen, die lediglich an den Rändern verklebt werden, anstelle von Platten kann ein flächiges Verkleben und - dadurch bedingt - ein zusätzlicher mechanischer Streß auf das Bauelement vermieden werden.

Die Applikation des Klebstoffes erfolgt insbesondere durch kapillaren Verguß, wodurch eine extrem kleine Klebefuge von 1 bis 30 µm erzeugt wird, im allgemeinen < 10 um. Dadurch ergibt sich eine minimale Angriffsfläche für Sauerstoff und Wasser. Durch die spezielle kationisch initiierte Härtung des Klebers, d.h. die UV-Härtung, wird gewissermaßen "ein" Polymermolekül erhalten, das frei ist von niedermolekularen, ausgasungsfähigen Bestandteilen, die die Performance der Dioden schädigen. Außerdem ist die Applikation des Klebstoffes in einer Inertgasatmosphäre möglich, die für die Handhabung der als Elektrodenmaterial dienenden luftempfindlichen Metalle, wie Calcium, erforderlich ist. Infolge der UV-Härtbarkeit wird ein rascher Prozeß mit einem Einkomponentenharz ermöglicht. Die Verkapselung kann auch zusätzlich zu auf den Bauelementen vorhandenen flächigen anorganischen Schutzschichten erfolgen; derartige Schutzschichten bestehen beispielsweise aus SiO₂ oder Si₃N₄.

An die UV-Härtung des Reaktionsklebstoffes kann sich vorteilhaft eine thermische Behandlung anschließen, vorzugsweise bis zu einer Temperatur von 120°C. Die Untergrenze der Temperatur liegt im allgemeinen etwa 10 bis 20°C unterhalb der Glasübergangstemperatur des gehärteten Klebstoffes. Durch die thermische Behandlung (Nachhärtung) kann die Barrierewirkung der Klebeschicht gegenüber Wasser und Sauerstoff weiter erhöht werden.

Das im Reaktionsklebstoff enthaltene Epoxidharz kann ein aliphatisches, cycloaliphatisches oder aromatisches Epoxid sein, wobei aliphatische und cycloaliphatische, d.h. ringepoxidierte Epoxide bevorzugt sind. Vorteilhaft besteht das Epoxidharz zu ≥ 70 Masse-% aus einem aliphatischen und/oder cycloaliphatischen Epoxid.

Als aliphatisches Epoxid dient insbesondere epoxidiertes Polybutadien oder epoxidiertes Sojabohnenöl; weitere einsetzbare Epoxide sind beispielsweise Dodecenoxid und Diglycidylester von Hexahydrophthalsäure. Die cycloaliphatischen Epoxide sind vorzugsweise Diepoxide. Derartige Diepoxide sind beispielsweise 3,4-Epoxycyclohexylmethyl-3',4'-epoxycyclohexancarboxylat (EEC) und Bis(3,4-epoxycyclohexylmethyl)-adipat. Weitere derartige Epoxide sind beispielsweise Verbindungen, bei denen die aus 4 Methyleneinheiten bestehende aliphatische Kette des Adipinsäurederivates durch eine Kette mit 5 bis 15 Methyleneinheiten ersetzt ist.

Der Reaktionsklebstoff weist vorteilhaft einen Gehalt von 3 bis 80 Masse-% an hydroxyfunktionellem Umsetzungsprodukt auf, das als haftungsverbessernde Komponente dient. Derartige Verbindungen, die an sich bekannt sind (DE 197 51 738 A1), können durch basenkatalysierte Umsetzung einer Epoxidverbindung mit einer phenolischen Verbindung hergestellt werden, wobei der basische Katalysator vorzugsweise ein Oniumhydroxid, wie Tetramethylammoniumhydroxid, ist: 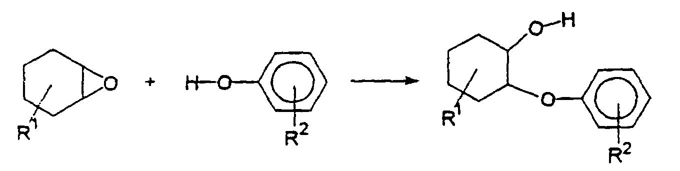 Der Rest R¹ kann dabei unreaktiv sein, wie dies beispielsweise bei einer Alkyl- oder Estergruppe der Fall ist, er kann aber auch epoxyfunktionell sein. Der Rest R² kann weitere phenolische Gruppen tragen, wodurch höhermolekulare Umsetzungsprodukte gebildet werden; für jede phenolische OH-Gruppe entsteht dabei eine aliphatische OH-Gruppe.

Die hydroxyfunktionellen Umsetzungsprodukte, die vorteilhaft eine Molmasse ≥ 500 besitzen, können zusätzlich auch noch Epoxidgruppen aufweisen, d.h. epoxyfunktionell sein; dies ist dann der Fall, wenn der Rest R¹ eine Epoxidgruppe trägt. Derartige Verbindungen können durch Umsetzung von bifunktionellen Epoxiden mit Bisphenolen im Molverhältnis von 2:1 bis 20:1 hergestellt werden, beispielsweise durch Umsetzung von Bisphenol A mit Bis(3,4-epoxycyclohexylmethyl)-adipat:

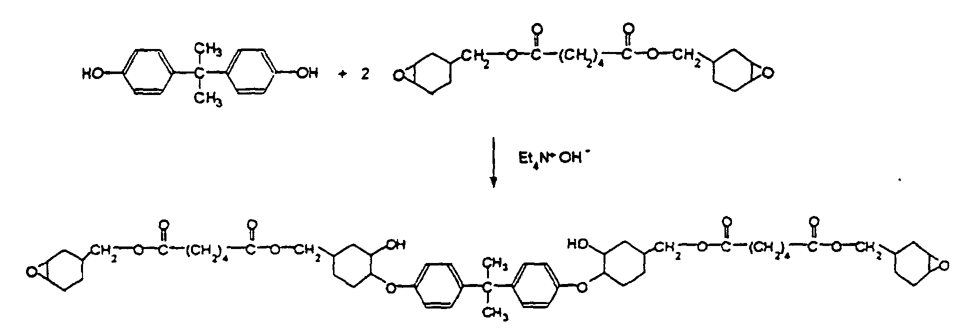

Das dabei als Katalysator eingesetzte Tetraethylammoniumhydroxid ist - wie auch andere Oniumhydroxide - thermolabil und zerfällt nach beendeter Reaktion zu flüchtigen und unschädlichen Produkten. Die hydroxyfunktionellen Umsetzungsprodukte enthalten deshalb keine Stoffe, welche die kationische Härtung des Reaktionsklebstoffes negativ beeinflussen könnten.

Die Haftvermittler auf Silanbasis sind insbesondere alkoxyfunktionelle Silane, im allgemeinen methoxy- und ethoxyfunktionelle Silane. Die Silane tragen üblicherweise mindestens eine weitere Gruppe, die über eine Si-C-Bindung gebunden ist, wie dies beispielsweise bei Glycidyloxypropyltrimethoxysilan der Fall ist. Der Haftvermittler wird dem Reaktionsklebstoff vorzugsweise in einer Menge von 0,05 bis 2 Masse-% zugesetzt.

Der Photoinitiator ist vorteilhaft ein Oniumsalz, insbesondere ein Triarylsulfoniumsalz mit Hexafluorophosphat, Hexafluoroarsenat oder Hexafluoroantimonat als Anion, wie Triphenylsulfonium-hexafluoroantimonat. Der Reaktionsklebstoff weist vorzugsweise einen Gehalt von 0,01 bis 5 Masse-% an Photoinitiator auf.

Der Reaktionsklebstoff kann auch Füllstoff enthalten. Als Füllstoff dienen mineralische Feinstmehle, insbesondere auf Kieselsäurebasis, beispielsweise Quarzmehle oder Quarzgutmehle, und feindisperse Kieselsäuren. Diese Füllstoffe werden verwendet, um den thermischen Ausdehnungskoeffizient des Klebstoffes abzusenken. Es kann daher von Bedeutung sein, wenn der Klebstoff hohe Anteile an Füllstoff unter Beibehaltung guter Fließeigenschaften verträgt. Im Reaktionsklebstoff können bis zu 70 Masse-% an Füllstoff enthalten sein. Der Füllstoff kann auch zur Verminderung der Feuchteaufnahme bzw. Diffusion und der Verringerung von Schwund dienen.

Neben dem Füllstoff können weitere an sich bekannte Zusätze bzw. Additive vorhanden sein, wie Farbstoffe, Pigmente, Netzhilfsmittel, Verlaufshilfsmittel, Haftvermittler, Thixotropierungsmittel, Entschäumer, Fließmodifikatoren, Stabilisatoren und Flammschutzmittel. Dadurch können dem Reaktionsklebstoff zusätzliche Eigenschaften, wie Farbe, spezielle rheologische Eigenschaften und Schwerentflammbarkeit, verliehen werden.

Der Reaktionsklebstoff kann vorteilhaft zusätzlich ein Polyol enthalten; dies sind insbesondere Polyester- und Polyetherpolyole. Beispiele sind Polyestertriole auf der Basis von Trimethylolpropan und ε-Caprolactam sowie Polyesterdiole, denen Ethylenglykol zugrunde liegt. Polyetherpolyole sind zahlreich verfügbar, die Kettenverlängerung erfolgt hierbei beispielsweise mit Ethylen- oder Propylenoxid. Die Polyole, die zur Modifizierung der mechanischen Eigenschaften des gehärteten Klebstoffes dienen, werden - je nach Molmasse und OH-Gehalt - in einer derartigen Menge eingesetzt, daß kein Überschuß von OH-Gruppen über Epoxidgruppen besteht.

Ferner kann der Reaktionsklebstoff zusätzlich eine oberflächenaktive Verbindung enthalten, insbesondere ein oberflächenaktives Siloxan; derartige Additive dienen als Entschäumer und Verlaufshilfsmittel. Der Anteil an der oberflächenaktiven Verbindung ist gering, er beträgt im allgemeinen lediglich 0,1 bis 0,5 Masse-%.

Anhand von Ausführungsbeispielen soll die Erfindung noch näher erläutert werden. Das Verfahren nach der Erfindung zur Kapselung von Bauelementen auf Basis organischer Halbleiter wird dabei am Beispiel von organischen lichtemittierenden Dioden beschrieben.

Die Herstellung der Dioden erfolgt nach bekannten Verfahren, beispielsweise durch Spin-coating, wenn Polymerlösungen verarbeitet werden, oder durch Aufdampfen im Vakuum, wenn Monomere eingesetzt werden. Als Substrat werden ITO-beschichtete Gläser verwendet (ITO = Indium Tin Oxide), wobei das ITO auch strukturiert sein kann; ITO dient als Anode. Falls erforderlich, werden Hilfsschichten, wie loch- und elektronenleitende Schichten verwendet. Als Kathode werden Metalle, wie Calcium, aufgedampft. Die mit dem Klebstoff zu verbindenden Teile sind das Glassubstrat, auf dem sich das Bauelement, in diesem Fall die organische lichtemittierende Diode, befindet, und eine Kappe, vorzugsweise aus Glas. Die zu fügenden Teile werden in einer inerten, d.h. insbesondere sauerstoff- und wasserfreien Atmosphäre zueinander positioniert.

Der Klebstoff wird von Hand mittels einer Spritze oder automatisch mittels eines Dispensers und eines xy-Tisches entlang den Rändern der (Glas-)Kappe appliziert und dringt aufgrund kapillar wirksamer Kräfte in die Klebefuge ein. Je nach Viskosität des Klebstoffes erfolgt dies im Bereich von Sekunden bis Minuten.

Die Exposition der Klebefuge gegenüber UV-Licht erfolgt mittels einer Lampe oder eines Lasers bei einer Wellenlänge, die der Absorption des im Klebstoff enthaltenen Photoinitiators entspricht. Im vorliegenden Fall wird die Bestrahlung mit einer Quecksilberdampflampe durchgeführt (Leistungsdichte im UV A-Bereich ca. 100 mW/cm², Bestrahlungsdauer 20 s). Durch eine anschließende thermische Behandlung bei 60°C für die Dauer von 20 min wird die Barrierewirkung gegenüber Wasser und Sauerstoff zusätzlich verbessert.

Im folgenden werden bevorzugt eingesetzte Klebstoff-Formulierungen beschrieben. Die für die jeweilige Formulierung benötigten Bestandteile werden in den angegebenen Mengen (Angaben in Masseteilen) zusammengerührt. Soweit vorhanden, wird der Füllstoff mittels einer Dispergierscheibe homogen verteilt.

| Reaktionsklebstoff Komponenten | Beispiel | | |
|---|---|---|---|
| | (1) | (2) | (3) |
| Cycloaliphatisches Epoxid | 80 | 80 | 17,9 |
| Aliphatisches Epoxid | 30 | 30 | 4,4 |
| Hydroxyfunktionelles Umsetzungsprodukt | 80 | 80 | 11,9 |
| Silan-Haftvermittler | 0,45 | 0,45 | 0,07 |
| Photoinitiator | 3 | 3 | 0,45 |
| Polyol | 97 | 97 | 21,4 |
| Oberfächenaktive Verbindung | 0,3 | 0,3 | 0,05 |
| Quarzgut-Feinstmehl (Füllstoff) | - | 320 | - |
| Feindisperse Kieselsäure (Füllstoff) | - | - | 14,5 |

Im einzelnen werden folgende Komponenten eingesetzt:
- Als cycloaliphatisches Epoxid dient ein Diepoxid, und zwar 3,4-Epoxycyclohexylmethyl-3',4'-epoxycyclohexancarboxylat (ECC); Epoxidwert: 0,74 mol/100 g.
- Das aliphatische Epoxid ist ein handelsübliches epoxidiertes Sojabchnenöl mit einem Gehalt von 6,3 % an Epoxidsauerstoff.
- Das hydroxyfunktionelle Umsetzungsprodukt (aus einem Epoxid und einem Phenol) ist ein Umsetzungsprodukt von 100 Masseteilen ECC mit 35 Masseteilen Bisphenol A.
- Als Silan-Haftvermittler dient handelsübliches Glycidyloxypropyltrimethoxysilan.
- Der Photoinitiator ist ein Gemisch von Triarylsulfoniumhexafluoroantimonaten; es wird eine handelsübliche ca. 50 %ige Lösung in Propylencarbonat eingesetzt.
- Das Polyol ist ein handelsübliches Polyestertriol; Molmasse: 900, Hydroxylwert: 0,33 mol/100 g.
- Die oberflächenaktive Verbindung ist ein handelsübliches oberflächenaktives Siloxan.
- Das Quarzgut-Feinstmehl ist ein handelsübliches feines rundgeschmolzenes Quarzgut mit einer mittleren Korngröße von 2,5 µm und einer maximalen Korngröße von 10 µm.
- Die feindisperse Kieselsäure ist eine handelsübliche flammhydrolisierte Kieselsäure mit einer Teilchengröße im Submikrometerbereich.

Zum Nachweis der Eignung und Wirksamkeit des Verfahrens nach der Erfindung werden die auf die beschriebene Weise gekapselten Dioden den nachfolgend beschriebenen Tests unterzogen. Hierbei handelt es sich um bestimmte, in der Mikroelektronik übliche Testverfahren. Als Beurteilungskriterien können dabei beispielsweise die Leuchtdichte (cd/m²), die Effizienz (cd/A, lm/W) und das Diodensperrverhältnis herangezogen werden.
- Lagerung gekapselter Dioden unter inerten Bedingungen mit anschließendem Vergleich der Dioden-Performance, beispielsweise der Lichtintensität:
   Auf die beschriebene Weise gekapselte Dioden werden sowohl bei Raumtemperatur als auch bei 85°C in Argon gelagert.
   Auch nach längerer Zeit, beispielsweise 6 Monate, zeigen die Dioden keine unterschiedliche Lichtintensität. Daraus ist ersichtlich, daß - aufgrund der speziellen Formulierung - aus dem Klebstoff keine die Dioden-Performance schädigenden Bestandteile freigesetzt werden. Die gekapselten Dioden zeigen nach dem Test keine mit bloßem Auge erkennbaren "dark spots"; dabei handelt es sich um nicht-lichtemittierende Bereiche. Derartige Degradationserscheinungen treten dagegen bei nicht geeigneten Epoxidharzen infolge des Ausgasens von niedermolekularen Bestandteilen auf.
- Temperaturschocktest gekapselter Dioden an Luft mit anschließendem Vergleich der Dioden-Performance, beispielsweise der Lichtintensität:
   Auf die beschriebene Weise gekapselte Dioden werden unter den folgenden Bedingungen an der Luft getestet: 100, 200 und 500 Cyclen im Temperaturbereich von -40°C bis +85°C in 10 min, Haltezeit jeweils 5 min. Der Vergleich der Lichtintensität von dem Test unterworfenen Dioden vor und nach dem Cyclen zeigt keine erkennbare Beeinträchtigung. Daraus ist ersichtlich, daß - aufgrund der speziellen Formulierung des Klebstoffes - eine ausreichende Dichtigkeit gegenüber Wasser und Sauerstoff erreicht wird. Die mit der speziellen Formulierung erzielbare ausgezeichnete Haftung und die an das Glas angepaßte thermische Ausdehnung gewährleisten die Dichtigkeit auch über einen größeren Temperaturbereich. Gekapselte Dioden zeigen nach dem Test keine mit bloßem Auge erkennbaren Veränderungen. Bei nicht geeigneten Epoxidharzen treten dagegen Degradationserscheinungen infolge des Eindringens von Luft und Feuchte auf.
- Temperatur/Feuchte-Cycletest gekapselter Dioden an Luft mit anschließendem Vergleich der Dioden-Performance, beispielsweise der Lichtintensität:
   Auf die beschriebene Weise gekapselte Dioden werden unter den folgenden Bedingungen an der Luft getestet: 100, 200 und 500 Cyclen im Temperaturbereich von 25 bis 55°C bei einer relativen Luftfeuchte > 94 % (IEC 68-2-30). Der Vergleich der Lichtintensität von dem Test unterworfenen Dioden vor und nach dem Cyclen zeigt keine erkennbare Beeinträchtigung. Gekapselte Dioden zeigen nach dem Test keine mit bloßem Auge erkennbaren Degradationserscheinungen, wie sie bei einer ungeeigneten Versiegelung auftreten.
- Lagertest gekapselter Dioden bei einer Temperatur von 85°C und einer relativen Feuchte von 85 % mit anschließendem Vergleich der Dioden-Performance, beispielsweise der Lichtintensität:
   Auf die beschriebene Weise gekapselte Dioden werden bei 85°C und einer relativen Feuchte von 85 % für jeweils 100, 200 und 500 und 1000 h an der Luft gelagert. Der Vergleich der Lichtintensität von dem Test unterworfenen Dioden vor und nach dem Test zeigt keine erkennbare Beeinträchtigung. Gekapselte Dioden zeigen nach dem Test keine mit bloßem Auge erkennbaren Degradationserscheinungen, wie sie bei einer ungeeigneten Versiegelung auftreten.
- Lagerung gekapselter Dioden bei einer konstanten Temperatur von 70°C für die Dauer von 1000 h mit anschließendem Vergleich der Dioden-Performance, beispielsweise der Lichtintensität:
   Auf die beschriebene Weise gekapselte Dioden werden bei 70°C 1000 h an der Luft gelagert. Der Vergleich der Lichtintensität von dem Test unterworfenen Dioden vor und nach dem Test zeigt keine erkennbare Beeinträchtigung. Gekapselte Dioden zeigen nach dem Test keine mit bloßem Auge erkennbaren Degradationserscheinungen, wie sie bei einer ungeeigneten Versiegelung auftreten.
- Temperaturschocktest mit gleichzeitiger elektrischer Belastung gekapselter Dioden an Luft mit anschließendem Vergleich der Dioden-Performance, beispielsweise der Lichtintensität:
   Auf die beschriebene Weise gekapselte Dioden werden unter den folgenden Bedingungen an der Luft getestet: 100, 200 und 500 Cyclen im Temperaturbereich von -40°C bis +85°C in 10 min, Haltezeit jeweils 5 min. Gleichzeitig werden die Dioden in einer geeigneten Vorrichtung elektrisch belastet.

Dabei wird für 90 s eine Spannung, beispielsweise im Bereich von 3 bis 15 V, an die Dioden angelegt. Die spannungsfreie Periode beträgt 270 s. Während der gesamten Zeit wird die Dioden-Performance kontinuierlich aufgezeichnet. Der Vergleich der Lichtintensität von dem Test unterworfenen Dioden vor und nach dem Test zeigt keine erkennbare Beeinträchtigung. Gekapselte Dioden zeigen nach dem Test keine mit bloßem Auge erkennbaren Degradationserscheinungen, wie sie bei einer ungeeigneten Versiegelung auftreten.
- Lagerung gekapselter Dioden bei einer Temperatur von 80°C und einer relativen Luftfeuchte von 80 % für mindestens 240 h mit anschließendem Vergleich der Dioden-Peformance, beispielsweise der Lichtintensität:
   Auf die beschriebene Weise gekapselte Dioden werden bei 80°C und einer relativen Feuchte von 85 % mindestens 240 h an der Luft gelagert. Der Vergleich der Lichtintensität von dem Test unterworfenen Dioden vor und nach dem Test zeigt keine erkennbare Beeinträchtigung. Gekapselte Dioden zeigen nach dem Test keine mit bloßem Auge erkennbaren Degradationserscheinungen, wie sie bei einer ungeeigneten Versiegelung auftreten.

## Patentansprüche

1. Verfahren zur Verkapselung von Bauelementen auf Basis organischer Halbleiter, insbesondere von organischen lichtemittierenden Dioden, wobei ein Gehäuse mit einem Substrat verklebt wird, **dadurch gekennzeichnet, daß** zur Verklebung ein UV-härtbarer Reaktionsklebstoff eingesetzt wird, der folgende Komponenten enthält:
• ein Epoxidharz,
• ein hydroxyfunktionelles Umsetzungsprodukt einer Epoxidverbindung mit einer phenolischen Verbindung,
• einen Haftvermittler vom Silantyp und
• einen Photoinitiator sowie
• gegebenenfalls Füllstoff.

2. Verfahren nach Anspruch 1, **dadurch gekennzeichnet, daß** das Epoxidharz zu ≥ 70 Masse-% ein aliphatisches und/oder cycloaliphatisches Epoxid ist.

3. Verfahren nach Anspruch 1 oder 2, **dadurch gekennzeichnet, daß** der Reaktionsklebstoff 3 bis 80 Masse-% hydroxyfunktionelles Umsetzungsprodukt enthält.

4. Verfahren nach einem der Ansprüche 1 bis 3, **dadurch gekennzeichnet, daß** der Reaktionsklebstoff 0,05 bis 2 Masse-% Silan enthält.

5. Verfahren nach einem oder mehreren der Ansprüche 1 bis 4, **dadurch gekennzeichnet, daß** der Photoinitiator ein Oniumsalz ist.

6. Verfahren nach einem oder mehreren der Ansprüche 1 bis 5, **dadurch gekennzeichnet, daß** der Füllstoff ein mineralisches Feinstmehl auf Kieselsäurebasis und/oder Kieselsäure ist.

7. Verfahren nach einem oder mehreren der Ansprüche 1 bis 6, **dadurch gekennzeichnet, daß** der Reaktionsklebstoff zusätzlich ein Polyol enthält.

8. Verfahren nach einem oder mehreren der Ansprüche 1 bis 7, **dadurch gekennzeichnet, daß** der Reaktionsklebestoff zusätzlich eine oberflächenaktive Verbindung, insbesondere ein oberflächenaktives Siloxan, enthält.

9. Verfahren nach einem oder mehreren der Ansprüche 1 bis 8, **dadurch gekennzeichnet, daß** das Bauelement nach der UV-Härtung einer thermischen Behandlung, vorzugsweise bis zu einer Temperatur von 120°C, unterworfen wird.

10. Verfahren nach einem oder mehreren der Ansprüche 1 bis 9, **dadurch gekennzeichnet, daß** als Gehäuse eine Kappe, insbesondere aus Glas, verwendet wird.

## Claims

1. Method of encapsulating components based on organic semiconductors, and especially organic light-emitting diodes, in which a housing is adhesively bonded to a substrate, **characterized in that** adhesive bonding is carried out using a UV-curable reactive adhesive comprising the following components:
• an epoxy resin,
• a hydroxy-functional reaction product of an epoxide compound with a phenolic compound,
• a silane-type adhesion promoter, and
• a photoinitiator, and also
• if desired, filler.

2. Method according to Claim 1, **characterized in that** the epoxy resin is to ≥ 70% by mass an aliphatic and/or cycloaliphatic epoxide.

3. Method according to Claim 1 or 2, **characterized in that** the reactive adhesive contains from 3 to 80% by mass of hydroxy-functional reaction product.

4. Method according to any of Claims 1 to 3, **characterized in that** the reactive adhesive contains from 0.05 to 2% by mass of silane.

5. Method according to one or more of Claims 1 to 4, **characterized in that** the photoinitiator is an onium salt.

6. Method according to one or more of Claims 1 to 5, **characterized in that** the filler is a very finely ground, silica-based mineral and/or silica.

7. Method according to one or more of Claims 1 to 6, **characterized in that** the reactive adhesive further comprises a polyol.

8. Method according to one or more of Claims 1 to 7, **characterized in that** the reactive adhesive further comprises a surface-active compound, in particular a surface-active siloxane.

9. Method according to one or more of Claims 1 to 8, **characterized in that** the component after UV curing is subjected to a thermal treatment, preferably up to a temperature of 120°C.

10. Method according to one or more of Claims 1 to 9, **characterized in that** a cover, in particular of glass, is used as housing.

## Revendications

1. Procédé pour encapsuler des pièces à base de semi-conducteurs organiques, en particulier de diodes organiques émettant de la lumière, en assemblant par collage un bâti avec un substrat, **caractérisé en ce qu'**on utilise pour le collage un adhésif réactif durcissant par UV, qui contient les composants suivants :
• une résine époxyde
• un produit de transformation à fonctionnalité hydroxy d'un composé époxyde avec un composé phénolique,
• un promoteur d'adhérence du type silane et
• un photo-initiateur ainsi que
• le cas échéant une charge.

2. Procédé selon la revendication 1, **caractérisé en ce que** la résine époxyde est, à raison de ≥70% en masse, un époxyde aliphatique et/ou cycloaliphatique.

3. Procédé selon la revendication 1 ou 2, **caractérisé en ce que** l'adhésif réactif contient 3 à 80% en masse de produit de transformation à fonctionnalité hydroxy.

4. Procédé selon l'une quelconque des revendications 1 à 3, **caractérisé en ce que** l'adhésif réactif contient 0,05 à 2% en masse de silane.

5. Procédé selon l'une ou plusieurs des revendications 1 à 4, **caractérisé en ce que** le photo-initiateur est un sel d'onium.

6. Procédé selon l'une ou plusieurs des revendications 1 à 5, **caractérisé en ce que** la charge est une poussière minérale finement divisée à base de silice et/ou de la silice.

7. Procédé selon l'une ou plusieurs des revendications 1 à 6, **caractérisé en ce que** l'adhésif réactif contient en outre un polyol.

8. Procédé selon l'une ou plusieurs des revendications 1 à 7, **caractérisé en ce que** l'adhésif réactif contient en outre un composé tensioactif, en particulier un siloxane tensioactif.

9. Procédé selon l'une ou plusieurs des revendications 1 à 8, **caractérisé en ce que** la pièce est soumise, après le durcissement aux UV, à un traitement thermique, de préférence jusqu'à une température de 120°C.

10. Procédé selon l'une ou plusieurs des revendications 1 à 9, **caractérisé en ce qu'**on utilise comme bâti un capuchon, en particulier en verre.
